# EUROPÄISCHE PATENTSCHRIFT

(11) **EP 3 306 329 B1**
(45) Veröffentlichungstag und Bekanntmachung des Hinweises auf die Patenterteilung: **15.01.2020**
(21) Anmeldenummer: 16192819.7
(22) Anmeldetag: 07.10.2016
(51) Int. Cl.: G01R 31/327, G01R 19/165, H02B 3/00, H02B 13/065, G05B 23/02

(54) **VERFAHREN ZUM ZENTRALEN ÜBERWACHEN VON ZUSTANDSWECHSELN EINER ANZAHL VON KOMPONENTEN FÜR HOCHSPANNUNGSANLAGEN AB 1 KV AUFWÄRTS**
METHOD FOR CENTRAL MONITORING OF CHANGES IN STATE OF A NUMBER OF COMPONENTS FOR HIGH VOLTAGE SYSTEMS FROM 1 KV UPWARDS
PROCÉDÉ DE SURVEILLANCE CENTRALE DE CHANGEMENTS D'ÉTAT D'UNE PLURALITÉ DE COMPOSANTS POUR INSTALLATIONS HAUTE TENSION À PARTIR DE 1 KV.

(43) Veröffentlichungstag der Anmeldung: 11.04.2018
(73) Patentinhaber: Technische Universität Graz, 8010 Graz (AT); Austrian Power Grid AG, 1220 Wien (AT)
(72) Erfinder: Weichinger, Günter, 3672 Maria Taferl (AT); Huska, Wolfgang, 2540 Bad Vöslau (AT); Fickert, Lothar, 8042 Graz (AT); Achleitner, Georg, 1150 Wien (AT); Pill, Ingo, 8010 Graz (AT); Wotowa, Franz, 1140 Wien (AT); Zachoval, Paul, 1130 Wien (AT)
(74) Vertreter: Patentanwaltskanzlei Matschnig & Forsthuber OG

(56) Entgegenhaltungen:
- CN-A- 104 407 286
- JP-A- 2012 130 141
- US-A1- 2011 012 603
- US-A1- 2015 276 877

## Beschreibung

Die Erfindung betrifft ein Verfahren zum zentralen Überwachen des korrekten Ablaufs von Zustandswechseln einer Anzahl von Komponenten für Hochspannungsanlagen ab 1 kV aufwärts, wobei jede zu überwachende Komponente dazu eingerichtet ist, zwischen zumindest zwei Zuständen zu wechseln, wobei jeder zu überwachenden Komponente ein elektrischer Antrieb zum Zustandswechseln der jeweiligen Komponente zugeordnet ist, wobei die Antriebe aus zumindest einer gemeinsamen Spannungsquelle über ein mit den Antrieben verbundenes Spannungsversorgungsnetz gespeist werden und die gemeinsame Spannungsquelle zu diesem Zweck das Spannungsversorgungsnetz an zumindest einem Einspeisepunkt speist.

Zudem betrifft die Erfindung ein Überwachungssystem für eine Hochspannungsanlage, umfassend eine Anzahl von zu überwachenden Komponenten für Hochspannungsanlagen ab 1 kV aufwärts, wobei jede zu überwachende Komponente dazu eingerichtet ist, zwischen zumindest zwei Zuständen zu wechseln, eine Anzahl an elektrischen Antrieben, wobei jeder zu überwachenden Komponente ein Antrieb zum Zustandswechsel der jeweiligen Komponente zugeordnet ist, zumindest eine gemeinsamen Spannungsquelle zur Versorgung der Antriebe, ein die gemeinsame Spannungsquelle mit den Antrieben verbindendes Spannungsversorgungsnetz, wobei die gemeinsame Spannungsquelle das Spannungsversorgungsnetz an zumindest einem Einspeisepunkt speist. Ferner betrifft die Erfindung eine Hochspannungsanlage umfassend ein erfindungsgemäßes Überwachungssystem.

In Hochspannungsanlagen, insbesondere in Umspannwerken und/oder Kraftwerken, werden Komponenten wie beispielsweise Leistungsschalter, Trenner, Lüfter oder Pumpen, die allesamt mittels eines elektrischen Antriebs (der vorzugsweise gleichspannungsgespeist sein kann) ihren Zustand wechseln können (Schalter beispielsweise zwischen einem Ein- und einem Ausschaltzustand, Lüfter und Pumpen zumindest zwischen einem Zustand, in dem sie in Betrieb sind und einem Zustand, in dem sie außer Betrieb sind), mit elektrischer Spannung (vorzugsweise Gleichspannung) versorgt. Damit können diese Geräte im Falle eines Notbetriebes über eine Spannungsquelle (z.B. eine Gleichspannungsquelle), insbesondere eine Batterie, versorgt werden.

Die Funktionalität solcher Geräte ist sehr wichtig für den sicheren Betrieb einer Hochspannungsanlage, die unter Umständen die Stromversorgung für große Gebiete sicherstellt. Aus diesem Grund ist es erforderlich, den technischen Zustand der Geräte durch regelmäßige Kontrollen zu überprüfen sowie gegebenenfalls erforderliche Wartungsarbeiten durchzuführen. Diese Kontrollen werden innerhalb bestimmter Zeitintervalle durch entsprechend geschultes Personal durchgeführt.

JP 2012 130141 A offenbart ein Verfahren gemäß dem Oberbegriff des Anspruchs 1.

Eine Aufgabe der Erfindung besteht darin, eine zusätzliche Möglichkeit zu schaffen, den technischen Zustand von Komponenten für Hochspannungsanlagen zentral und dauerhaft überprüfen zu können.

Diese Aufgabe wird mit einem Verfahren der eingangs genannten Art gelöst, das die folgenden Schritte umfasst:
a) Erfassen eines Ist-Signals von Spannung- und/oder Strom, die/der durch die Spannungsquelle an dem Einspeisepunkt an das Spannungsversorgungsnetz abgegeben wird/werden,
b) Vergleichen des Ist-Signals mit zumindest einem vordefinierten Soll-Signal,
c) wobei ergebnisabhängig von dem Vergleich unter Punkt b) auf den korrekten oder fehlerhaften Ablauf eines Zustandswechsels zumindest einer überwachten Komponente rückgeschlossen wird.

Gemäß der Erfindung ist das Soll-Signal zeitlich veränderlich und wird in Abhängigkeit einer von außen zugeführten Schaltinformation bestimmt.

Durch das Erfassen des Ist-Signals von Spannung- und/oder Strom, die/der durch die Spannungsquelle an dem Einspeisepunkt an das Spannungsversorgungsnetz abgegeben wird, wird eine zentrale Erfassung des Zustands der Komponenten, insbesondere eine zentrale Überwachung ermöglicht, indem das Ist-Signal in Schritt b) mit einem Soll-Signal (dabei kann es sich beispielsweise um einen vordefinierten Signalverlauf, insbesondere ein Signalmuster handeln) verglichen wird, wobei gemäß Schritt c) ergebnisabhängig von dem Vergleich unter Punkt b) auf den korrekten oder fehlerhaften Ablauf eines Zustandswechsels zumindest einer überwachten Komponente rückgeschlossen wird. Die Überwachung bzw. das Monitoring der Komponenten kann damit zentral erfolgen. Zudem kann die Überwachung dauerhaft vorgesehen sein, sodass ein fehlerhafter Ablauf eines Zustandswechsels - z.B. wenn der mechanische Aufbau eines Trennschalters gebrochen ist und der Schalter deshalb nicht mehr in eine Schließstellung gebracht werden kann - z.B. daran erkannt werden kann, dass der an dem Einspeisepunkt in das Spannungsversorgungsnetz eingespeiste Strom weniger stark oder weniger lange ansteigt, als aufgrund eines korrekten Zustandswechsels zu erwarten ist, beispielsweise weil der Antrieb aufgrund des Defekts des Trennschalters "leer" läuft. Der Ausdruck "Hochspannungsanlage" beschreibt Anlagen, bei denen Hochspannungskomponenten für Spannungen ab 1 kV eingesetzt werden. Beispielsweise können dies Umspannwerke aber auch Kraftwerke sein.

Das erfindungsgemäße Verfahren ist auch für Hochspannungsanlagen anwendbar, die zwei oder mehrere Spannungsquellen sowie Einspeisepunkte aufweisen. Die Spannungsquellen können parallel zu einer gemeinsamen Spannungsquelle zusammengefasst sein oder auch voneinander getrennt angeordnet sein. Auch ist es möglich, dass das Ist-Signal als Summe der Teilsignale an zwei oder mehreren Einspeisepunkten erfasst wird. Das Erfassen von Spannung und/oder Strom kann ebenso Verhältnisse oder Produkte davon erfassen. Beispielsweise kann damit der Widerstand oder die Leistungsaufnahme der Antriebe oder die für den Zustandswechsel benötigte Arbeit erfasst werden. Generell können beliebige Netzparameter erfasst werden, die dazu geeignet sind, um auf den korrekten Ablauf des Zustandswechsels einer überwachten Komponente rückschließen zu lassen.

Unter dem Ausdruck "eine Anzahl von" wird im Rahmen dieser Offenbarung - sofern nicht anders angegeben - eine Anzahl von zumindest zwei verstanden, beispielsweise zumindest zwei, drei, vier oder mehr, insbesondere zumindest zehn, zwanzig oder mehr betragen kann. Der Fachmann ist in der Lage, die Anzahl der zu überwachenden Komponenten bzw. Antriebe der jeweiligen Anwendung entsprechend zu wählen.

Es kann vorgesehen sein, dass die Spannungsquelle eine Gleichspannungsquelle ist und die elektrischen Antriebe mittels dem Spannungsversorgungsnetz mit Gleichspannung der Gleichspannungsquelle versorgt sind. Das Vorsehen einer Gleichspannungsquelle, beispielsweise eines Batteriespeichers, ermöglicht eine besonders zuverlässige und autarke Energieversorgung der elektrischen Antriebe.

Die Erfindung ist ebenso für den Einsatz für Wechselstromsysteme geeignet. So könnte die Spannungsquelle eine Wechselspannungsquelle sein, das Spannungsnetz ein Wechselspannungsnetz und die Antriebe mittels Wechselspannung oder entsprechend gleichgerichteter Gleichspannung versorgt werden.

Insbesondere kann vorgesehen sein, dass zumindest eine der zu überwachenden Komponenten ein elektrisches Schaltelement ist. Elektrische Schaltelemente sind beispielsweise Lastschalter, Leistungsschalter, Trennschalter oder Lasttrennschalter. Auch können eine Vielzahl der zu überwachenden Komponenten oder alle der zu überwachenden Komponenten Schaltelemente sein. Die Überwachung kann sozusagen indirekt erfolgen, indem über den erwartungsgemäßen Verlauf des Ist-Signals von Spannung- und/oder Strom auf die korrekte Funktion des Antriebs bzw. des durch den Antrieb in seinem Zustand veränderten Schaltelements rückgeschlossen werden kann.

Ergänzend oder alternativ dazu kann vorgesehen sein, dass zumindest eine der zu überwachenden Komponenten ein Lüfter für einen Transformator oder eine Pumpe oder ein Lastschalter ist.

Das erfindungsgemäße Verfahren ist besonders günstig einsetzbar, wenn die Hochspannungsanlage eine Umspannanlage ist, und eine Vielzahl der zu überwachenden elektronischen Komponenten Schaltelemetente sind, die dazu eingerichtet sind, Hochspannungsleitungen zu verbinden oder zu trennen.

Zudem kann vorgesehen sein, dass nach Feststellen eines fehlerhaften Ablaufs eines Zustandswechsels zumindest einer überwachten Komponente in Schritt c) in einem nachfolgenden Schritt d) eine Fehlerroutine ausgelöst wird. Eine Fehlerroutine kann beispielweise eine automatisierte Ausgabe einer Fehlermeldung, insbesondere die Herausgabe einer Benachrichtigung an geeignetes Fachpersonal umfassen. Auch könnte in einer Fehlerroutine die Abschaltung einzelner Zweige einer Hochspannungsanlage umfassen.

Im Prinzip kann die Erfassung des Ist-Signals in Schritt a) auf beliebige Art und Weise erfolgen, wobei die Auswahl einer geeigneten Messung von dem Anwendungsfall des erfindungsgemäßen Verfahrens abhängig ist. Im einfachsten Fall kann ein Maximalwert des Ist-Signal erfasst werden, der in Schritt b) mit einem Schwellwert verglichen wird. In einer Weiterbildung des Verfahrens kann hingegen vorgesehen sein, dass in Schritt a) der zeitliche Verlauf des Ist-Signals von Spannung- und/oder Strom erfasst wird, wodurch eine detailliertere Überwachung von einzelnen Komponenten ermöglicht wird. So können durch genaue Erfassung des zeitlichen Verlaufs des Ist-Signals unter Umständen Rückschlüsse auf die Komponenten gezogen werden, insbesondere, wenn typische Spannungs- oder Stromprofile beispielsweise von Zustandswechseln in Form von Schaltvorgängen von Schaltelementen einen charakteristischen Verlauf aufweisen, der sich in dem Ist-Signal abbildet und durch Vergleich mit einem geeignet gewählten Soll-Signal erfasst werden kann.

Insbesondere kann vorgesehen sein, dass in Schritt b) die Abweichung des Ist-Signals von dem Soll-Signal ermittelt wird und in einem Schritt b) nachfolgenden Schritt zur Beurteilung der Leichtgängigkeit des Zustandswechsels herangezogen wird. Dadurch kann beispielsweise auf den Verschleiß der Komponente oder des Antriebs der Komponente (bzw. die zu erwartende verbleibende Lebensdauer) oder auf eine aus einem anderen Grund verursachte Schwergängigkeit des Zustandswechsels der jeweilig überwachten Komponente rückgeschlossen werden. Wird mangelnde Leichtgängigkeit des Zustandswechsels beispielsweise anhand einer erhöhten Stromaufnahme des jeweiligen Antriebs erkannt, so kann z.B. eine Meldung ausgegeben werden, wonach die jeweilige Komponente bzw. der zugehörige Antrieb zu überprüfen ist. Dadurch können technische Defekte vorgebeugt werden, was insbesondere bei fernsteuerbaren Umspannwerken von besonderer Bedeutung sein kann. Umgekehrt kann aus sprunghaft zunehmender Leichtgängigkeit ebenfalls auf eine Antriebsstörung z.B. Gestängebruch, Zahnradbruch, Kettenriss oder Ähnliches gefolgert werden.

Zudem kann vorgesehen sein, dass bei Überschreiten der Abweichung zwischen Ist-Signal und dem Soll-Signal um einen vordefinierten Wert eine Wartungsmitteilung ausgegeben wird.

Weiters kann vorgesehen sein, dass einzelne Antriebe in Verbindung mit den zu überwachende Komponenten während der Zeitdauer des Zustandswechsels der Komponenten voneinander unterscheidbare charakteristische Spannungs- und/oder Stromverläufe aufweisen, wobei das Soll-Signal eine Auswahl der charakteristischen Spannungs- und/oder Stromverläufe umfasst, wobei durch Prüfung einer definierbaren Übereinstimmung des in Schritt a) erfassten Ist-Signals mit dem Soll-Signal die einem festgestellten Zustandswechsel zugeordnete zu überwachenden Komponente identifiziert wird. Das Maß der definierbaren Übereinstimmung kann beispielsweise in Kenntnis der charakteristischen Stromaufnahme oder Leistungsaufnahme des Antriebs der zu überwachenden Komponente festgelegt werden, wobei ab einer signifikanten Übereinstimmung der Zustandswechsel des jeweiligen Antriebs bzw. der jeweiligen Komponente erkannt wird. Aufgrund der unterschiedlichen Bauformen diverser Schalter, beispielsweise Trennschalter und Leistungsschalter, lassen sich Schaltvorgänge bzw. Zustandswechsel derselben sowohl hinsichtlich der Strom- und Leistungsaufnahme ihrer Antriebe als auch hinsichtlich der Zeitdauer, bis der Zustandswechsel abgeschlossen ist, voneinander unterscheiden - die charakteristische Strom- oder Leistungsaufnahme von Trennschaltern und Lastschaltern ist folglich in vorbekannter Weise unterschiedlich. Diese Feststellung kann in dem Soll-Signal abgebildet werden. Auch kann aufgrund einer Abweichung von einem charakteristischen Verlauf beispielsweise auf Verschleiß der jeweiligen Komponente rückgeschlossen werden.

Gemäss der Erfindung ist das Soll-Signal zeitlich veränderlich und wird in Abhängigkeit einer von außen zugeführten Schaltinformation bestimmt. Das Soll-Signal kann damit dynamisch an die zu erwartenden Schaltvorgänge bzw. Zustandswechsel der jeweiligen Komponenten angepasst werden. Die Schaltinformation kann extern beispielsweise durch eine Steuerung zugeführt und zur Festlegung des zeitlichen Verlaufs des Soll-Signals herangezogen werden. Insbesondere enthält die Schaltinformation Informationen darüber, wann ein Schaltelement geschaltet wird und damit seinen Zustand wechselt. Ebenso kann die Schaltinformation Informationen darüber enthalten, welche Schaltelemente wann geschaltet werden, sodass der charakteristische Schaltverlauf des jeweiligen Schaltelements bei der Festlegung des zeitlichen Verlaufs des Soll-Signals berücksichtigt werden kann.

Zur zusätzlichen Erhöhung der Betriebssicherheit einer Hochspannungsanlage sowie seiner Überwachung mit dem erfindungsgemäßen Verfahren kann vorgesehen sein, dass die Abfolge der Zustandswechsel der Komponenten dergestalt vorgegeben ist, dass zu jedem Zeitpunkt maximal drei Zustandswechsel einander zeitlich überschneiden. Durch eine Beschränkung auf maximal drei einander zeitlich überlappender Zustandswechsel wird einerseits eine gleichzeitige Schaltung eines Drei-Phasen-Energieübertragungssystems ermöglicht, gleichzeitig aber verhindert, dass weitere Schaltelemente geschalten werden, wodurch eine zuverlässige Überwachung vereinfacht wird. Sofern für die Anwendung in Zweiphasensystemen wie beispielsweise in Bahnversorgungsystemen vorgesehen ist, kann die maximale Anzahl der einander überlappenden Schaltvorgänge ebenso auf zwei reduziert werden. Generell ist das erfindungsgemäße Verfahren weitläufig einsetzbar und kann z.B. ebenso zur Überwachung des Potentials des Sternpunktes eines Transformators eingesetzt werden.

Ein weiterer Aspekt der Erfindung betrifft ein Überwachungssystem der eingangs genannten Art, welches erfindungsgemäß eine Messvorrichtung zur Erfassung eines Ist-Signals von Spannung- und/oder Strom an dem Einspeisepunkt sowie eine mit der Messvorrichtung verbundene Recheneinheit aufweist, der das durch die Messvorrichtung erfasste Ist-Signal sowie zumindest ein vordefinierbares Soll-Signal zugeführt ist, wobei die Recheneinheit dazu eingerichtet ist, das Ist-Signal mit dem Soll-Signal zu vergleichen und ergebnisabhängig von dem Vergleich auf den korrekten oder fehlerhaften Ablauf eines Zustandswechsels zumindest einer überwachten Komponente rückzuschießen, wobei das Soll-Signal zeitlich veränderlich ist und in Abhängigkeit einer von außen zugeführten Schaltinformation bestimmt wird. Durch die Erfassung des Ist-Signals von Spannung und/oder Strom an dem Einspeisepunkt ist eine zentrale Überwachung der Komponenten ermöglicht. Zudem kann das erfindungsgemäße Überwachungssystem unter Umständen an bestehenden Hochspannungsanlagen in einfacher Weise implementiert werden, wenn z.B. die Hochspannungsanlage bereits eine Recheneinheit aufweist, die über ausreichende Verarbeitungskapazität verfügt, um die genannten Abläufe, insbesondere den Vergleich des Ist-Signals mit dem Soll-Signal durchzuführen. In diesem Fall müsste lediglich die Messvorrichtung zusätzlich implementiert und die bestehende Recheneinheit adaptiert werden.

Insbesondere kann das Überwachungssystem zur Durchführung des Verfahrens gemäß sämtlichen angeführten Verfahrensansprüchen eingerichtet sein bzw. die in diesem Zusammenhang genannten oder erforderlichen Merkmale aufweisen.

So kann beispielsweise vorgesehen sein, dass die Spannungsquelle eine Gleichspannungsquelle ist und die elektrischen Antriebe mittels dem Spannungsversorgungsnetz mit Gleichspannung der Gleichspannungsquelle versorgt sind. Weiters betrifft die Erfindung eine Hochspannungsanlage, insbesondere ein Umspannwerk, umfassend ein erfindungsgemäßes Überwachungssystem.

Die Erfindung ist im Folgenden anhand einer beispielhaften und nicht einschränkenden Ausführungsform näher erläutert, die in den Figuren veranschaulicht ist. Darin zeigt
Figur 1 eine schematische Darstellung eines erfindungsgemäßen Überwachungssystems,
Figur 2 eine konkrete Ausgestaltung des Überwachungssystems gemäß Figur 1,
Figur 3a eine schematische Darstellung eines Stromverlaufs eines korrekten Ablaufs eines Zustandswechsels dreier überwachter Komponenten gemäß Figur 2, und
Figur 3b eine schematische Darstellung eines Stromverlaufs eines fehlerhaften Ablaufs eines Zustandswechsels einer der drei überwachter Komponenten gemäß Figur 2.

In den folgenden Figuren bezeichnen - sofern nicht anders angegeben - gleiche Bezugszeichen gleiche Merkmale.

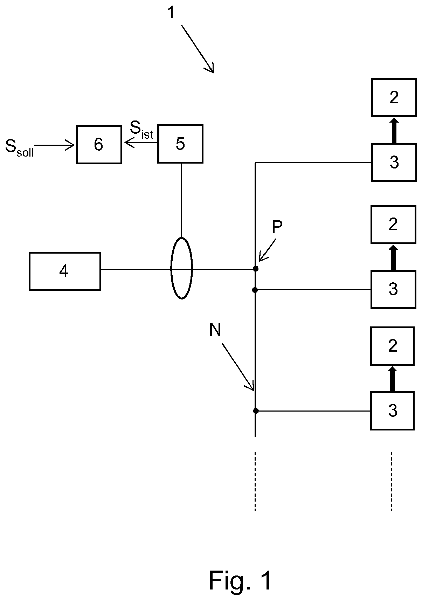

Figur 1 zeigt eine schematische Darstellung eines erfindungsgemäßen Überwachungssystems 1 für eine Hochspannungsanlage ab Spannungen von 1 kV aufwärts. Das Überwachungssystem 1 umfasst eine Anzahl von zu überwachenden Komponenten 2 für die Hochspannungsanlage, beispielsweise Schaltelemente, Lüfter oder Pumpen. Jede zu überwachende Komponente 2 ist dazu eingerichtet, zwischen zumindest zwei Zuständen zu wechseln, i.e. ein Schaltelement zwischen einem Ein- und einem Ausschaltzustand, ein Lüfter oder eine Pumpe zumindest zwischen einem Ein- und einen Auszustand, in der der Lüfter oder die Pumpe in Betrieb bzw. außer Betrieb ist.

Das Überwachungssystem 1 umfasst zudem eine Anzahl an im vorliegenden Beispiel gleichspannungsgespeisten Antrieben 3, wobei jeder zu überwachenden Komponente 2 ein Antrieb 3 zum Zustandswechseln der jeweiligen Komponente 2 zugeordnet ist, sowie zumindest eine gemeinsamen Spannungsquelle 4, im vorliegenden Fall beispielhaft eine Gleichspannungsquelle, zur Versorgung der Antriebe 3. Selbstverständlich kann das erfindungsgemäße Überwachungssystem auch für wechselspannungsversorgte Antriebe 3 eingesetzt werden bzw. könnte anstatt der Gleichspannungsquelle 4 eine Wechselspannungsquelle vorgesehen sein.

Ferner umfasst das Überwachungssystem 1 ein die gemeinsame Gleichspannungsquelle 4 mit den Antrieben 3 verbindendes Spannungsversorgungsnetz N, im vorliegenden Fall ein Gleichspannungsversorgungsnetz, wobei die gemeinsame Gleichspannungsquelle 4 das Gleichspannungsversorgungsnetz N an zumindest einem Einspeisepunkt P speist.

Erfindungsgemäß umfasst das Überwachungssystem 1 zudem eine Messvorrichtung 5 zur Erfassung eines Ist-Signals Sᵢₛₜ von Spannung- und/oder Strom an dem Einspeisepunkt P sowie eine mit der Messvorrichtung 5 verbundene Recheneinheit 6, der das durch die Messvorrichtung 5 erfasste Ist-Signal Sᵢₛₜ sowie zumindest ein vordefinierbares Soll-Signal Sₛₒₗₗ zugeführt ist, wobei die Recheneinheit 6 dazu eingerichtet ist, das Ist-Signal Sᵢₛₜ mit dem Soll-Signal Sₛₒₗₗ zu vergleichen und ergebnisabhängig von dem Vergleich auf den korrekten oder fehlerhaften Ablauf eines Zustandswechsels zumindest einer überwachten Komponente 2 rückzuschließen.

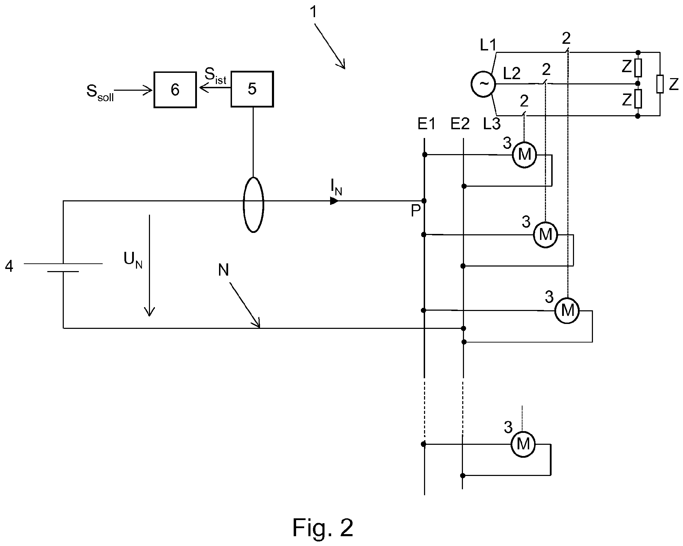

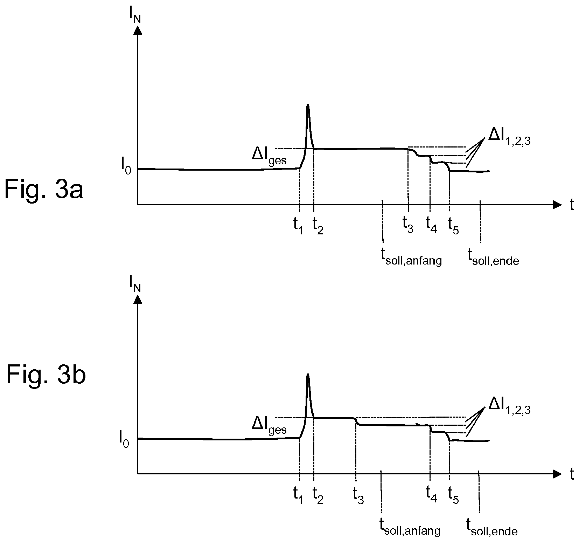

Figur 2 zeigt eine konkrete Ausgestaltung des Überwachungssystems gemäß Figur 1. Darin ist eine Gleichspannungsquelle 4 dargestellt, die eine Netzspannung U_{N} an ein Gleichspannungsversorgungsnetz N abgibt und einen Versorgungsstrom I_{N} in das Gleichspannungsversorgungsnetz N hin zu einem Einspeisepunkt P speist, über den mit Sammelschienen E1 und E2 verbundene Antriebe 3, die in den Figuren durch das elektrische Schaltsymbol M für elektrische Maschinen dargestellt sind. Typischerweise handelt es sich bei den Antrieben 3 um Gleichspannungsmotoren. Die Antriebe 3 sind in diesem Beispiel mechanisch mit den zu überwachenden Komponenten 2 gekoppelt, bei denen es sich beispielsweise um Trennschalter handelt. Diese stehen üblicherweise über ein elektrisch isolierendes Keramikgestänge mit einer Antriebswelle dergestalt in mechanischem Eingriff, dass eine Drehbewegung der Antriebswelle des Antriebs 3 in eine Offen- oder Schließbewegung des Trennschalters umgesetzt wird (gleiches kann natürlich für beliebige anderer Arten von Schalter gelten). Die Antriebe 3 verfügen beispielsweise über eine maximale Antriebsleistung von 400 W, weshalb bei einer Versorgungsspannung von beispielsweise 220 V Gleichspannung Ströme in Höhe von mehr als 1 A durch die Antriebe aus dem Gleichspannungsnetz N aufgenommen werden können. Es wurde festgestellt, dass beispielsweise die Stromaufnahme seitens der Antriebe 3 zur Ermittlung des korrekten Ablaufs eines Zustandswechsels eine Komponente 2, insbesondere eines Schaltelements, herangezogen werden kann, wie mit Blick auf die Figuren 3a und 3b noch im Detail erörtert wird. Zu diesem Zweck ist eine Erfassung eines Signals Sᵢₛₜ erforderlich, das einen Netzparameter, insbesondere dem Netzstrom I_{N} repräsentiert. In dem gezeigten Ausführungsbeispiel wird dieser Versorgungsstrom I_{N} durch die Messvorrichtung 5 erfasst und der Recheneinheit 6 zugeführt. Im vorliegenden Beispiel gemäß Figur 2 sind die Komponenten 2 Trennschalter, die zum Trennen oder Verbinden einzelner Phasen L1, L2 und L3 eines Hochspannungsnetzes mit nachgeschalteten Leitungsabzweigen vorgesehen sind, über die Verbraucher Z versorgt werden können. Bei dem Hochspannungsnetz kann es sich beispielsweise um ein 20 kV, 110 kV, 220 kV oder 380 kV Netz handeln.

Figur 3a zeigt eine schematische Darstellung eines Stromverlaufs des Gleichspannungsnetzstroms I_{N} eines korrekten Ablaufs eines Zustandswechsels dreier überwachter Komponenten 2 gemäß Figur 2. Darin ist erkennbar, wie der Strom ausgehend von einer Grundlast I₀ aufgrund der Einleitung von Schaltvorgängen zum Zeitpunkt t₁ von den in Figur 2 gezeigten Trennschaltern sprunghaft ansteigt. Dieser sprunghafte Anstieg ist durch den relativ hohen Anlaufstrom der Antriebe 3 bedingt, und senkt sich zum Zeitpunkt t2 hin zu einem relativ konstanten Wert, der beispielsweise um ΔI_{ges} = 3 A höher als der Grundlaststrom I₀ liegen kann, was bei einer Versorgungsspannung von 220 V einer zusätzlichen Leistungsaufnahme von 660 W durch die drei Antriebe 3 aus dem Netz N entspricht. Der Grundlaststrom I₀ ist durch weitere Verbraucher im Gleichspannungsversorgungsnetz N verursacht und kann natürlich von dem beispielhaften Verlauf und Höhe abweichen. Abhängig von der jeweiligen Ausgestaltung der zu überwachenden Komponente ist eine gewisse Zeitdauer zu erwarten, innerhalb der der Zustandswechsel abgeschlossen sein sollte. Basierend auf dieser vorbekannten Information kann ein Sollwert Sₛₒₗₗ zu dem zu erwartenden Stromsignal (und/oder Spannungssignal) gebildet werden. Im vorliegenden Beispiel wurde z.B. ein Zeitkriterium mit den zeitlichen Schranken t_{soll,anfang} und t_{soll,ende} dargestellt, wobei der Zustandswechsel als korrekt eingestuft wird, wenn der gestufte Rückgang des Netzstromes I_{N} hin zu dem Grundlaststrom innerhalb des Zeitfensters t_{soll,anfang} <= t <= t_{soll,ende} erfolgt. Der gestufte Verlauf des Rückgang des Netzstromes I_{N} ist darin begründet, dass die Leistungsaufnahme des jeweiligen Antriebs 3 nach Abschluss des Zustandswechsels des jeweiligen Trennschalters rasch abnimmt, da keine mechanische Leistung an den jeweiligen Trennschalter bzw. die den Trennschalter ansteuernde Mechanik abgegeben werden muss. Zum Zeitpunkt t₂ ist der erhöhte Anlaufstrom der elektrischen Antriebe 3 abgeklungen. Zum Zeitpunkt t₃ hat der erste Antrieb den Zustandswechsel eines ersten Trennschalters durchgeführt, zum Zeitpunkt t₄ folgt der zweite Antrieb und zum Zeitpunkt t₅ hat der dritte Antrieb den dritten Trennschalter erfolgreich in einen komplementären Zustand gewechselt. Diese Zustandswechsel sind im vorliegenden Beispiel anhand des gestuften Stromverlaufs erkennbar, wobei nach Ende jeder Stromstufe ΔI_{1,2,3,} der jeweilige Zustandswechsel abgeschlossen ist. Die Stromstufen ΔI_{1,2,3} können z.B. z.B. 1A betragen. Alle Zeitpunkte liegen innerhalb des erwarteten Zeitfensters t_{soll,anfang} bis t_{soll,ende}, weshalb auf einen korrekten Ablauf der Zustandswechsel rückgeschlossen werden kann. Beispielhaft können die Zeitpunkte t₂ bis t₅ sowie bis t_{soll,ende} ausgehend von Zeitpunkt t₁ wie folgt lauten: t₂= t₁+ x₁ Sekunden, t₃= t₁ + x_{2,1} Sekunden, t₄ = t₁ + x_{2,2} Sekunden und t₄ = t₁ + x_{2,3} Sekunden, wobei die Zeitdauer x₁ beispielsweise zwischen 50 und 500ms, typischerweise 200ms betragen kann und die Zeitdauern x_{2,1bis3} beispielsweise zwischen 3 und 10 Sekunden, insbesondere zwischen 5 und 6 Sekunden liegen können. Im vorliegenden Beispiel liegt der Zeitpunkt t_{soll,anfang} etwa 5 bis 7 Sekunden nach t1. Der Zeitpunkt t_{soll,ende} liegt etwa 10 bis 15 Sekunden nach t1. Das Zeitfenster, in der der Zustandswechsel der zu überwachenden Komponenten 2 abgeschlossen sein sollte, beträgt daher im vorliegenden Beispiel zwischen 3 und 10 Sekunden. Die konkreten jeweils festzulegenden Zahlenwerte sind in Abhängigkeit der zu überwachenden Komponenten 2 sowie der zugehörigen Antriebe 3 zu bestimmen.

Die Messung des Stromes I_{N} bildet im vorliegenden Fall das Istsignal Sᵢₛₜ und das Sollsignal Sₛₒₗₗ wird in Kenntnis des zu erwartenden Verlaufs des Stromsignals eines korrekten Zustandswechsels der Recheneinheit 6 vorgegeben. Auch ist es denkbar, dass die Recheneinheit 6 selbständig zu erwartende Signale errechnet bzw. ein selbstlernender Algorithmus zur Bestimmung des Sollsignals Sₛₒₗₗ Anwendung findet. Als weiteres Kriterium kann beispielsweise die Höhe der Stromstufe, die Fläche gebildet aus Strom und Zeit, oder ein Spannungsabfall bei der Spannungsquelle 4 herangezogen werden. Auch ist es denkbar, dass einzelne Komponenten 2 gemeinsam mit den sie antreibenden Antrieben 3 charakteristische Muster in ihrer Stromaufnahme zeigen, sodass anhand des Verlaufes des Istsignals Sᵢₛₜ bereits einzelne Komponenten 2 identifiziert werden können. Weiters kann aus der Kombination von Strom und Spannung ein Leistungsverlauf errechnet werden, auch dieser Verlauf kann zur Beurteilung herangezogen werden.

Figur 3b zeigt eine schematische Darstellung eines Stromverlaufs des Gleichspannungsnetzstroms I_{N} eines fehlerhaften Ablaufs eines Zustandswechsels einer der drei überwachten Komponenten gemäß Figur 2. Darin steigt der Strom wie erwartet sprunghaft zum Zeitpunt t₁ an. Zum Zeitpunkt t2 beträgt der Wert des Stromes erwartungsgemäß I_{N} = 10 + ΔI_{ges}. Zum Zeitpunkt t3 bricht beispielsweise ein Antriebsgestänge einer der Trennschalter, was zu einem abrupten Abfall der Leistungsaufnahme des zugeordneten Antriebs führt. Der Abfall der Leistungsaufnahme äußert sich in dem Absinken des Netzstromes I_{N} zum Zeitpunkt t3, und zwar zu einem Zeitpunkt, der noch außerhalb des Sollbereiches liegt. Das Istsignal Sᵢₛₜ weicht damit in unzulässiger Weise von dem Sollsignal Sₛₒₗₗ ab, weshalb auf einen fehlerhaften Ablauf des Zustandswechsels einer zu überwachenden Komponente 2, im vorliegenden Fall eines Trennschalters, rückgeschlossen werden kann und geeignete Fehlerroutinen ausgelöst werden können.

Erfindungsgemäß können der Recheneinheit 6 Schaltinformationen zugeführt werden, die bereits Informationen zu den zu erwartenden Schaltzeitpunkten einzelner Schaltelemente enthalten. Basierend darauf können besonders präzise Vorgaben des Sollsignals Sₛₒₗₗ gemacht werden, indem beispielsweise die zu erwartenden Anfangszeitpunkte t1 eines Schaltvorganges vorbekannt sind.

In Anbetracht dieser Lehre ist der Fachmann in der Lage, ohne erfinderisches Zutun zu anderen, nicht gezeigten Ausführungsformen der Erfindung zu gelangen. Die Erfindung ist daher nicht auf die gezeigte Ausführungsform beschränkt. Auch können einzelne Aspekte der Erfindung bzw. der Ausführungsform aufgegriffen und miteinander kombiniert werden. Wesentlich sind die der Erfindung zugrunde liegenden Gedanken, die durch einen Fachmann in Kenntnis dieser Beschreibung in mannigfaltiger Weise ausgeführt werden können und trotzdem als solche aufrechterhalten bleiben.

## Patentansprüche

1. Verfahren zum zentralen Überwachen des korrekten Ablaufs von Zustandswechseln einer Anzahl von Komponenten (2) für Hochspannungsanlagen ab 1 kV aufwärts, wobei jede zu überwachende Komponente (2) dazu eingerichtet ist, zwischen zumindest zwei Zuständen zu wechseln, wobei jeder zu überwachenden Komponente (2) ein elektrischer Antrieb (3) zum Zustandswechseln der jeweiligen Komponente (2) zugeordnet ist, wobei die Antriebe (3) aus zumindest einer gemeinsamen Spannungsquelle (4) über ein mit den Antrieben (3) verbundenes Spannungsversorgungsnetz (N) gespeist werden und die gemeinsame Spannungsquelle (4) zu diesem Zweck das Spannungsversorgungsnetz (N) an zumindest einem Einspeisepunkt (P) speist, umfassend die folgenden Schritte:
a) Erfassen eines Ist-Signals (Sᵢₛₜ) von Spannung- und/oder Strom, die/der durch die Spannungsquelle (4) an dem Einspeisepunkt (P) an das Spannungsversorgungsnetz (N) abgegeben wird/werden,
b) Vergleichen des Ist-Signals (Sᵢₛₜ) mit zumindest einem vordefinierten Soll-Signal (Sₛₒₗₗ),
c) wobei ergebnisabhängig von dem Vergleich unter Punkt b) auf den korrekten oder fehlerhaften Ablauf eines Zustandswechsels zumindest einer überwachten Komponente (2) rückgeschlossen wird,
**dadurch gekennzeichnet, dass** das Soll-Signal (Sₛₒₗₗ) zeitlich veränderlich ist und in Abhängigkeit einer von außen zugeführten Schaltinformation bestimmt wird.

2. Verfahren nach Anspruch 1, wobei die Spannungsquelle (4) eine Gleichspannungsquelle ist und die elektrischen Antriebe (3) mittels dem Spannungsversorgungsnetz (N) mit Gleichspannung der Gleichspannungsquelle versorgt.

3. Verfahren nach Anspruch 1 oder 2, wobei zumindest eine der zu überwachenden Komponenten (2) ein elektrisches Schaltelement ist.

4. Verfahren nach einem der Ansprüche 1 bis 3, wobei zumindest eine der zu überwachenden Komponenten (2) ein Lüfter für einen Transformator, oder eine Pumpe ist.

5. Verfahren nach einem der vorhergehenden Ansprüche, wobei die Hochspannungsanlage ein Umspannwerk ist, und eine Vielzahl der zu überwachenden elektronischen Komponenten (2) Schaltelemetente sind, die dazu eingerichtet sind, Hochspannungsleitungen zu verbinden oder zu trennen.

6. Verfahren nach einem der vorhergehenden Ansprüche, wobei nach Feststellen eines fehlerhaften Ablaufs eines Zustandswechsels zumindest einer überwachten Komponente (2) in Schritt c) in einem nachfolgenden Schritt d) eine Fehlerroutine ausgelöst wird.

7. Verfahren nach einem der vorhergehenden Ansprüche, wobei in Schritt a) der zeitliche Verlauf des Ist-Signals (Sᵢₛₜ) von Spannung- und/oder Strom erfasst wird.

8. Verfahren nach einem der vorhergehenden Ansprüche, wobei in Schritt b) die Abweichung des Ist-Signals (Sᵢₛₜ) von dem Soll-Signal (Sₛₒₗₗ) ermittelt wird und in einem Schritt b) nachfolgenden Schritt zur Beurteilung der Leichtgängigkeit des Zustandswechsels herangezogen wird.

9. Verfahren nach Anspruch 8, wobei bei Überschreiten der Abweichung zwischen Ist-Signal (Sᵢₛₜ) und dem Soll-Signal (Sₛₒₗₗ) um einen vordefinierten Wert eine Wartungsmitteilung ausgegeben wird.

10. Verfahren nach einem der vorhergehenden Ansprüche, wobei einzelne Antriebe (3) in Verbindung mit den zu überwachende Komponenten (2) während der Zeitdauer des Zustandswechsels der Komponenten (2) voneinander unterscheidbare charakteristische Spannungs- und/oder Stromverläufe aufweisen, wobei das Soll-Signal (Sₛₒₗₗ) eine Auswahl der charakteristischen Spannungs- und/oder Stromverläufe umfasst, wobei durch Prüfung einer definierbaren Übereinstimmung des in Schritt a) erfassten Ist-Signals (Sᵢₛₜ) mit dem Soll-Signal (Sₛₒₗₗ) die einem festgestellten Zustandswechsel zugeordnete zu überwachenden Komponente (2) identifiziert wird.

11. Verfahren nach einem der vorhergehenden Ansprüche, wobei die Abfolge der Zustandswechsel der Komponenten (2) dergestalt vorgegeben ist, dass zu jedem Zeitpunkt maximal drei Zustandswechsel einander zeitlich überschneiden.

12. Überwachungssystem (1) für eine Hochspannungsanlage, umfassend
- eine Anzahl von zu überwachenden Komponenten (2) für Hochspannungsanlagen ab 1 kV aufwärts, wobei jede zu überwachende Komponente (2) dazu eingerichtet ist, zwischen zumindest zwei Zuständen zu wechseln,
- eine Anzahl an elektrischen Antrieben (3), wobei jeder zu überwachenden Komponente (2) ein Antrieb (3) zum Zustandswechsel der jeweiligen Komponente (2) zugeordnet ist,
- zumindest eine gemeinsamen Spannungsquelle (4) zur Versorgung der Antriebe (3),
- ein die gemeinsame Spannungsquelle (4) mit den Antrieben (3) verbindendes Spannungsversorgungsnetz (N), wobei die gemeinsame Spannungsquelle (4) das Spannungsversorgungsnetz (N) an zumindest einem Einspeisepunkt (P) speist, **dadurch gekennzeichnet, dass** das Überwachungssystem (1) zudem
- eine Messvorrichtung (5) zur Erfassung eines Ist-Signals (Sᵢₛₜ) von Spannung- und/oder Strom an dem Einspeisepunkt (P) sowie
- eine mit der Messvorrichtung (5) verbundene Recheneinheit (6) aufweist, der das durch die Messvorrichtung (5) erfasste Ist-Signal (Sᵢₛₜ) sowie zumindest ein vordefinierbares Soll-Signal (Sₛₒₗₗ) zugeführt ist, wobei die Recheneinheit (6) dazu eingerichtet ist, das Ist-Signal (Sᵢₛₜ) mit dem Soll-Signal (Sₛₒₗₗ) zu vergleichen und ergebnisabhängig von dem Vergleich auf den korrekten oder fehlerhaften Ablauf eines Zustandswechsels zumindest einer überwachten Komponente (2) rückzuschließen, wobei das Soll-Signal (Sₛₒₗₗ) zeitlich veränderlich ist und in Abhängigkeit einer von außen zugeführten Schaltinformation bestimmt wird.

13. Überwachungssystem nach Anspruch 12, wobei die Spannungsquelle (4) eine Gleichspannungsquelle ist und die elektrischen Antriebe (3) mittels dem Spannungsversorgungsnetz (N) mit Gleichspannung der Gleichspannungsquelle versorgt sind.

14. Hochspannungsanlage, insbesondere Umspannwerk, umfassend ein Überwachungssystem nach Anspruch 12 oder 13.

## Claims

1. A method for centrally monitoring the correct sequence of state changes of a number of components (2) for high-voltage systems from 1 kV upwards, wherein each component (2) to be monitored is designed for changing between at least two states, wherein an electric drive (3) is assigned to each component (2) to be monitored in order to change the state of the respective component (2), and wherein the drives (3) are energized by at least one common voltage source (4) via a voltage supply network (N) that is connected to the drives (3) and the common voltage source (4) for this purpose energizes the voltage supply network (N) in at least one feeding point (P), with said method comprising the following steps:
a) acquiring an actual signal (Sᵢₛₜ) of the voltage and/or current, which is/are delivered to the voltage supply network (N) by the voltage source (4) at the feeding point (P), and
b) comparing the actual signal (Sᵢₛₜ) with at least one predefined nominal signal (Sₛₒₗₗ),
c) wherein the correct or incorrect sequence of a state change of at least one monitored component (2) is deduced in dependence on the result of the comparison under point b),
**characterized in that** the nominal signal (Sₛₒₗₗ) is time-variable and determined in dependence on externally supplied switching information.

2. The method according to claim 1, wherein the voltage source (4) is a d.c. voltage source and supplies the electric drives (3) with the d.c. voltage of the d.c. voltage source via the voltage supply network (N).

3. The method according to claim 1 or 2, wherein at least one of the components (2) to be monitored is an electric switching element.

4. The method according to one of claims 1 to 3, wherein at least one of the components (2) to be monitored is a ventilator for a transformer or a pump.

5. The method according to one of the preceding claims, wherein the high-voltage system is a transformer substation and a plurality of the electronic components (2) to be monitored are switching elements, which are designed for connecting or disconnecting high-voltage lines.

6. The method according to one of the preceding claims, wherein an error routine is triggered in a subsequent step d) after the detection of an incorrect sequence of a state change of at least one monitored component (2) in step c).

7. The method according to one of the preceding claims, wherein the chronological sequence of the actual signal (Sᵢₛₜ) of the voltage and/or current is acquired in step a).

8. The method according to one of the preceding claims, wherein the deviation of the actual signal (Sᵢₛₜ) from the nominal signal (Sₛₒₗₗ) is determined in step b) and used for evaluating the ease of the state change in a step that follows step b).

9. The method according to claim 8, wherein a service message is output if the deviation between the actual signal (Sᵢₛₜ) and the nominal signal (Sₛₒₗₗ) exceeds a predefined value.

10. The method according to one of the preceding claims, wherein individual drives (3) have in connection with the components (2) to be monitored characteristic voltage and/or current profiles, which can be distinguished from one another, during the duration of the state change of the components (2), wherein the nominal signal (Sₛₒₗₗ) comprises a selection of the characteristic voltage and/or current profiles, and wherein the component to be monitored (2), which is associated with a detected state change, is identified by checking a definable correspondence of the actual signal (Sᵢₛₜ) acquired in step a) with the nominal signal (Sₛₒₗₗ).

11. The method according to one of the preceding claims, wherein the sequence of the state changes of the components (2) is predefined in such a way that no more than three state changes chronologically overlap one another at any point in time.

12. A monitoring system (1) for a high-voltage system, comprising
- a number of components (2) to be monitored for high-voltage systems from 1 kV upwards, wherein each component (2) to be monitored is designed for changing between at least two states,
- a number of electric drives (3), wherein a drive (3) is assigned to each component (2) to be monitored in order to change the state of the respective component (2),
- at least one common voltage source (4) for energizing the drives (3), and
- a voltage supply network (N) that connects the common voltage source (4) to the drives (3), wherein the common voltage source (4) energizes the voltage supply network (N) in at least one feeding point (P), **characterized in that** the monitoring system (1) furthermore comprises
- a measuring device (5) for acquiring an actual signal (Sᵢₛₜ) of the voltage and/or current at the feeding point (P), as well as
- a processing unit (6) that is connected to the measuring device (5), wherein the actual signal (Sᵢₛₜ) acquired by the measuring device (5) and at least one predefinable nominal signal (Sₛₒₗₗ) are transmitted to said processing unit, wherein the processing unit (6) is designed for comparing the actual signal (Sᵢₛₜ) with the nominal signal (Sₛₒₗₗ) and for deducing the correct or incorrect sequence of a state change of at least one monitored component (2) in dependence on the result of the comparison, and wherein the nominal signal (Sₛₒₗₗ) is time-variable and determined in dependence on externally supplied switching information.

13. The monitoring system according to claim 12, wherein the voltage source (4) is a d.c. voltage source and the electric drives (3) are supplied with the d.c. voltage of the d.c. voltage source via the voltage supply network (N).

14. A high-voltage system, particularly a transformer substation, comprising a monitoring system according to claim 12 or 13.

## Revendications

1. Procédé de surveillance centralisée du déroulement correct de changements d'état d'un certain nombre de composants (2) destinés à des installations à haute tension à partir de 1 kV en montant, dans lequel chaque composant à surveiller (2) est conçu pour alterner entre deux états, étant associée à chaque composant à surveiller (2) une commande électrique (3) pour le changement d'état du composant respectif (2), les commandes (3) étant alimentées à partir d'au moins une source de tension commune (4) par un réseau d'alimentation en tension (N) connecté aux commandes (3) et la source de tension commune (4) alimentant pour ce faire le réseau d'alimentation en tension (N) à au moins un point d'alimentation (P), comprenant les étapes suivantes :
a) détection d'un signal réel (S_{réel}) de tension et/ou de courant émis par la source de tension (4) au point d'alimentation (P) vers le réseau d'alimentation en tension (N),
b) comparaison du signal réel (S_{réel}) avec au moins un signal théorique prédéfini (S_{théo}),
c) en fonction du résultat de la comparaison du point b), il est conclu à un déroulement correct ou défectueux d'un changement d'état d'au moins un composant à surveiller (2),
**caractérisé en ce que** le signal théorique (S_{théo}) est variable dans le temps et est défini en fonction d'une information de commutation communiquée depuis l'extérieur.

2. Procédé selon la revendication 1, dans lequel la source de tension (4) est une source de tension continue et les commandes électriques (3) sont alimentées en tension continue par la source de tension continue au moyen du réseau d'alimentation en tension (N).

3. Procédé selon la revendication 1 ou 2, dans lequel au moins un des composants à surveiller (2) est un élément de commutation électrique.

4. Procédé selon une des revendications 1 à 3, dans lequel au moins un des composants à surveiller (2) est un ventilateur pour un transformateur ou une pompe.

5. Procédé selon une des revendications précédentes, dans lequel l'installation à haute tension est un poste de transformation, et une multitude de composants électroniques à surveiller (2) sont des éléments de commutation qui sont conçus pour connecter ou pour séparer des câbles à haute tension.

6. Procédé selon une des revendications précédentes, dans lequel, après constatation d'un déroulement défectueux d'un changement de tension d'au moins un composant à surveiller (2) dans l'étape c), une routine d'erreur est déclenchée dans une étape suivante d).

7. Procédé selon une des revendications précédentes, dans lequel, dans l'étape a), l'évolution dans le temps du signal réel (S_{réel}) du courant et ou de la tension est détectée.

8. Procédé selon une des revendications précédentes, dans lequel, dans l'étape b), l'écart du signal réel (S_{réel}) par rapport au signal théorique (S_{théo}) est déterminé et est utilisé dans une étape suivant l'étape b) pour évaluer l'aisance du changement d'état.

9. Procédé selon la revendication 8, dans lequel, en cas de dépassement de l'écart entre le signal réel (S_{réel}) et le signal théorique (S_{théo}) à raison d'une valeur prédéfinie, un communiqué de maintenance est émis.

10. Procédé selon une des revendications précédentes, dans lequel les commandes individuelles (3), en connexion avec les composants à surveiller (2) pendant la durée du changement d'état des composants (2), présentent des évolutions de tension et/ou de courant caractéristiques différentiables les unes des autres, le signal théorique (S_{théo}) comprenant une sélection des évolutions de tension et/ou de courant caractéristiques, le composant à surveiller (2) associé à un changement d'état constaté étant identifié par contrôle d'une concordance définissable du signal réel (S_{réel}) détecté dans l'étape a) avec le signal théorique (S_{théo}) .

11. Procédé selon une des revendications précédentes, dans lequel la succession des changements d'état des composants (2) est prédéfinie de manière à ce que, à chaque moment, au maximum trois changements d'état se recouvrent temporellement les uns des autres.

12. Système de surveillance (1) pour installation à haute tension, comprenant
- un certain nombre de composants à surveiller (2) destinés à des installations à haute tension à partir de 1 kV en montant, chaque composant à surveiller (2) étant conçu pour alterner entre au moins deux états,
- un certain nombre de commandes électriques (3), étant associée à chaque composant à surveiller (2) une commande (3) pour le changement d'état des composants respectifs (2),
- au moins une source de tension commune (4) destinée à l'alimentation des commandes (3),
- un réseau d'alimentation en tension (N) connectant la source de tension commune (4) aux commandes (3), la source de tension commune (4) alimentant le réseau d'alimentation en tension (N) à au moins un point d'alimentation (P), **caractérisé en ce que** le système de surveillance (1) présente en outre
- un dispositif de mesure (5) destiné à détecter un signal réel (S_{réel}) de tension et/ou de courant au point d'alimentation (P) et
- une unité de calcul (6) connectée au dispositif de mesure (5) et à laquelle le signal réel (S_{réel}) détecté par le dispositif de mesure (5) ainsi qu'au moins un signal théorique (S_{théo}) prédéfinissable sont communiqués, l'unité de calcul (6) étant conçue pour comparer le signal réel (S_{réel}) avec le signal théorique (S_{théo}) et, en fonction du résultat de la comparaison, conclure au déroulement correct ou défectueux d'un changement d'état d'au moins un composant à surveiller (2), le signal théorique (S_{théo}) étant variable dans le temps et étant défini en fonction d'une information de commutation communiquée depuis l'extérieur.

13. Système de surveillance selon la revendication 12, dans lequel la source de tension (4) est une source de tension continue et les commandes électriques (3) sont alimentées en tension continue par la source de tension continue au moyen du réseau d'alimentation en tension (N).

14. Installation à haute tension, en particulier poste de transformation, comprenant un système de surveillance selon la revendication 12 ou 13.
